# EUROPEAN PATENT APPLICATION

(11) **EP 4 099 403 A1**
(43) Date of publication of application: **07.12.2022**
(21) Application number: 21914089.4
(22) Date of filing: 22.12.2021
(51) Int. Cl.: H01L 31/0224, H01L 31/068, H01L 31/18

(54) **SOLAR CELL AND FRONT ELECTRODE THEREOF, AND MANUFACTURING METHOD**

(30) Priority: 30.12.2020 CN 202011621762
(71) Applicant: Tongwei Solar (Chengdu) Co., Ltd., Chengdu, Sichuan 610299 (CN); Tongwei Solar (Meishan) Co., Ltd., Meishan, Sichuan 620010 (CN); Tongwei Solar (Jintang) Co., Ltd., Chengdu City Sichuan 610400 (CN); TONGWEI SOLAR (HEFEI) CO., LTD., Hefei, Anhui 230088 (CN); TONGWEI SOLAR (ANHUI) CO., LTD., Hefei, Anhui 230088 (CN)
(72) Inventor: HUANG, Zhi, Chengdu city, Sichuan 610299 (CN); ZHANG, Lin, Chengdu city, Sichuan 610299 (CN); XIA, Wei, Chengdu city, Sichuan 610299 (CN); XU, Guanqun, Chengdu city, Sichuan 610299 (CN); XU, Tao, Chengdu city, Sichuan 610299 (CN); WAN, Liubin, Chengdu city, Sichuan 610299 (CN); PENG, Biao, Chengdu city, Sichuan 610299 (CN); GU, Feng, Chengdu city, Sichuan 610299 (CN); ZHAI, Xujin, Chengdu city, Sichuan 610299 (CN); XIE, Taihong, Chengdu city, Sichuan 610299 (CN)
(74) Representative: Marks & Clerk LLP
(86) International application number: PCT/CN2021/140577
(87) International publication number: WO 2022/143352

(57) **Abstract**

The present disclosure relates to a high-efficiency and high-reliability PERC solar cell and a front electrode thereof, and a manufacturing method, which belong to the solar cell technology. Busbars of the front electrode of solar cell of the present disclosure includes fine busbars and solder joints distributed on the fine busbars at intervals. Each fine busbar between adjacent solder joints includes a straight fine busbar connecting the two solder joints, and side fine busbars located on both sides of the straight fine busbar respectively. In the method for manufacturing the front electrode, the busbars and the fingers are printed by a step-by-step printing process. In the present disclosure, quality and reliability of the solar cell can be effectively improved while the conversion efficiency of the solar cell is improved.

## Description

### CROSS-REFERENCE TO RELATED DISCLOSURES

This application claims priority to Chinese patent application No. 2020116217625 filed with the Chinese Patent Office on December 30, 2020, entitled "High-efficiency and High-reliability PERC Solar Cell and Front Electrode thereof, and Manufacturing Method", the entire content of which is incorporated by reference.

### TECHNICAL FIELD

This disclosure relates to the solar cell technology, and in particular, to a solar cell and a front electrode thereof, and a manufacturing method.

### BACKGROUND

A crystalline silicon solar cell is a device that uses the photovoltaic effect of PN junction to convert light energy into electrical energy. A passivated emitter and rear contact (PERC) cell has been gradually developed to a mainstream high-efficiency solar cell product and technology in the market. How to further improve the conversion efficiency of the PERC cell, narrow the conversion efficiency difference with other high-efficiency cells such as a heterojunction technology (HJT) cell, a tunnel oxide passive contact (TOPCon) cell, and maintain the comprehensive cost-performance advantage of the PERC cell is an issue that PERC+ technology continues to face in future.

Moreover, the PERC cell module has received increasing attention from researchers and customers in reliability and durability performance. Various attenuation phenomena such as PID effect, LID, LETID, backplane's aging and cracking, EVA's yellowing and other issues can affect the lifetime of photovoltaic modules. With the development of the photovoltaic technology, the warranty period of photovoltaic modules has been extended from 5 years to at least 25 years. Accordingly, the International Renewable Energy Laboratory (IREL) has conducted indoor accelerated aging tests on crystalline silicon modules (including ISC61215 and UL1703 standards) to assess the factory quality of the modules and to approximate the long-term reliability of the modules during their warranty period under outdoor operating conditions. From a long-term perspective, high-efficiency and high-reliability cells and modules are still the main direction for the future development of the photovoltaic industry.

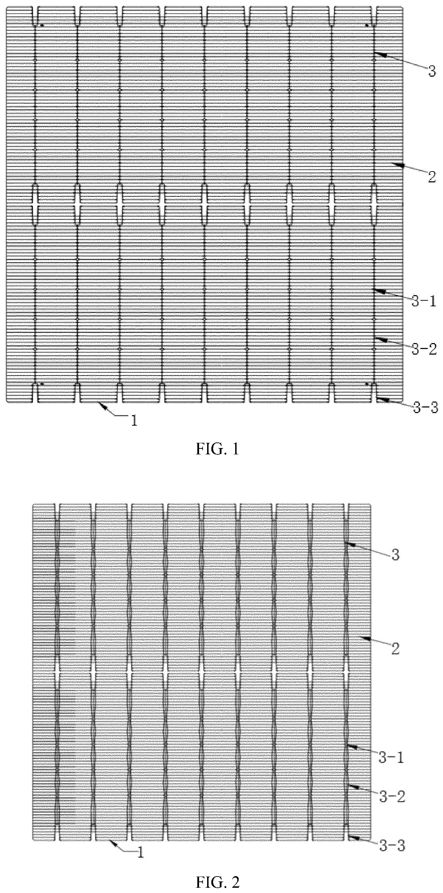

Metallization of front electrodes is one of the important aspects of solar cells to improve efficiency and reduce cost. A Multi-Busbar (MBB) cell (with nine or more busbars), on the one hand, can significantly improve cell efficiency, and on the other hand, can effectively reduce consumption of silver paste, thus the MBB technology is gradually increasing its market share and further developing to busbar-free technology. At present, in order to ensure the reliability, the welding accuracy and tensile strength of the modules, a design of a MBB pattern (as shown in Fig. 1) is generally focus on solder joints 3-1, fine busbars 3-2 and edge harpoon-shaped fine busbars 3-3 in a busbar area. In the process of module soldering, a molten tin of a solder strip and silver paste of the busbar form a silver-tin alloy at high temperature to achieve metal connection. In this case, the tension is mainly provided by the welding between the solder joint and the solder strip on the busbar. However, the fine busbar may have an increased resistance after soldering because of less silver paste, which affects the current collection in some areas. Besides, due to a width of the fine busbar is significantly smaller than that of the solder strip, the solder strip may be misaligned to a certain extent during the soldering process, so that the solder strip in the fine busbar area may be soldered with a finger perpendicular to the busbar, which may easily cause the finger to be broken or partial broken in the soldering area, resulting that the electroluminescence (EL) may indicate a broken line after the soldering process. Eventually, in the process of actual use, after long-term environmental aging, the resistance in this area may become larger due to smaller adhesion or fracture problem, eventually leading to a continuous decline in power generation, affecting product quality and reliability.

On account of above problems, a patent application No. CN201820897922.0 provides a front electrode structure of a multi-busbar solar cell and a solar cell having the same. In this patent application, the finger includes a straight section and a deformation section, the deformation section is disposed at an intersection area of the finger and the busbar, a width of the deformation section gradually widens from an end of the straight section to the busbar, a height of the deformation section is greater than a height of the straight section, and a total width of the deformation section is greater than or equal to a width of a solder pad. That is, in this patent application, a deformation area is designed at a connection area of a fine busbar and the finger to increase the total amount of silver paste in the area, thereby addressing the problem of the finger breakage in the soldering process of the multiple busbar solar cell to a certain extent. Nevertheless, the effect is not very satisfactory, and further improvement is still needed.

In another example, a Chinese patent application No. CN201711417592.7 discloses a new type of multi-busbar solar cell and a photovoltaic module using the multi-busbar solar cell, the busbar is designed as a double-line and flat ellipse-type composite shape structure, an end point of each small flat ellipse is taken as a welding reinforcement point to improve its reliability. By using the double-line composite busbar, when one end of the busbar has defects such as aging and broken, the other end of the busbar can still collect current normally, which would not cause reduction of the overall power generation substantially. The use of the busbar structure in this application is beneficial to avoid the soldering effect of the fine busbar and the solder strip to a certain extent, but may reduce the current collection effect of the fine busbar and the soldering connection.

Therefore, how to ensure the quality and reliability of the solar cell while improving the conversion efficiency of the solar cell has become a difficult problem to be continuously solved in the solar cell technology.

### SUMMARY

A purpose of the present disclosure is to solve the problem that the quality and reliability of an existing PERC solar cell need to be further improved, and to provide a high-efficiency and high-reliability PERC solar cell, a front electrode thereof and a manufacturing method. The technical solutions of the present disclosure can effectively improve the quality and reliability of the solar cell while improving the conversion efficiency of the solar cell.

In order to solve the above-mentioned problems, the technical solutions adopted in this disclosure are as follows.

The present disclosure provides a front electrode of a solar cell. A busbar of the front electrode includes fine busbars and solder joints distributed on the fine busbars at intervals. Each fine busbar between adjacent solder joints includes a straight fine busbar connecting the two solder joints, and side fine busbars located on both sides of the straight fine busbar respectively.

Further, a width of the straight fine busbars and a width of the side fine busbars are both 0.06±0.04mm.

Further, the side fine busbars are disposed divergently with respect to each solder joint, and a spacing W2 between the two side fine busbars is greater than a width W1 of the solder joint.

Further, each side fine busbar between adjacent solder joints is a straight line or a curve line. More preferably, each side fine busbar between adjacent solder joints is a straight line parallel to the straight fine busbar, and two ends of each side fine busbar are connected to the solder joints respectively by a transition connection line.

Further, two ends of each straight fine busbar are respectively connected to a central region of the two solder joints, and the side fine busbars on both sides of each straight fine busbar are symmetrically distributed with respect to the corresponding straight fine busbar.

Furthermore, fingers of the front electrode are printed by a knotless screen.

Further, the two ends of the fine busbars are provided with edge harpoon fine busbars, and the edge harpoon fine busbars are designed with an S-type curve line.

Further, the fingers are vertically distributed with the busbars, and a spacing between adjacent fingers ranges from 1.00mm to 1.32mm, and a width of the fingers ranges from 10µm to 26µm.

The present disclosure further provides a method for manufacturing the front electrode of the solar cell, including: forming the busbars and the fingers by using a step-by-step printing process.

Further, the solder joints and the fine busbars are synchronously printed during a process of printing the busbar area; and the fingers and the edge harpoon-shaped fine busbars are synchronously printed during a process of printing the finger area.

Furthermore, the fingers area is printed by a knotless screen.

The present disclosure further provides a solar cell includes the front electrode as described.

Compared with the existing technology, the beneficial effects of the present disclosure will be described as below.

First, in the front electrode of the solar cell of the present disclosure, the design of the structure of the busbars is optimized, the fine busbar between adjacent solder joints is designed as a composite structure including a straight fine busbar and side fine busbars on both sides. In this way, on the premise of effectively ensuring the current collection effect of the connection between the fine busbars and the solder scrips, the fingers can be prevented from breaking at the soldering area of the busbars. That is, the influence on the solar cell and the solar cell module caused by the soldering connections between the fine busbars and the solder scrips in an existing front electrode can be overcome, thereby improving the quality and reliability of the solar cell and the solar cell module.

Second, in the front electrode of the solar cell of the present disclosure, the fingers are printed by using the knotless screen, which can eliminate the knots in the warp and weft in the steel wire mesh on the fingers, and effectively improve the ink permeability of silver paste of screen printing and the fluctuation issue of 3D topography of grid lines. Besides, by the cooperation of the knotless screen printing technology, the optimized design of the busbar structure and the step-by-step printing technology, the present disclosure can effectively solve the problem that missing print may be easily formed at the knot positions of the busbar area when using the knotless screen printing technology, which further ensures the quality and reliability of the solar cell products.

Third, in the front electrode of the solar cell of the present disclosure, the edge harpoon-shaped fine busbar at each of the both ends of the fine busbar is designed as a S-type curve line, which can effectively reduce the knots formed by the longitudinal and transverse wires of the wire mesh in the harpoon-shaped busbar area by more than 80%, thereby further improving the quality and reliability of the solar cell products.

Fourth, in the method of manufacturing the front electrode of the solar cell of the present disclosure, by designing multiple fine busbars of the composite structure and the S-type harpoon-shaped fine busbar structure, the knotless screen printing process of the fingers, and the step-by-step printing process of the busbar area and the finger area, the photoelectric conversion efficiency of the PERC solar cell can be improved by more than 0.1%, and the consumption of front silver paste can be reduced by 3-10mg. Meanwhile, the quality and reliability of the solar cell and the solar cell module can also be effectively improved.

Fifth, in the method for manufacturing the front electrode of the solar cell of the present disclosure, the fingers are printed by using the knotless screen technology and the step-by-step printing process, which eliminates the problem of poor ink permeability of the front silver paste and the fluctuation issue of the grid lines caused by knots of the steel mesh. This can break the limitation that the paste of fingers has a high requirement of tensile force on the busbar area, thereby improving the metallization performance of the fingers area, and reducing the width of the fingers to 10-26µm, and reducing the shading area and the consumption of the silver paste. Moreover, the spacing between adjacent fingers can be effectively reduced to 1.00mm-1.32mm, which matches the diffusion sheet resistance of 155-250Ω/□, and improves the conversion efficiency of the solar cell.

Sixth, in the high-efficiency and high-reliability PERC solar cell of the present disclosure, by optimizing the structure of the front electrode, the impact caused by the soldering of the busbar area of the front electrode and the knotless screen process for printing the fingers can be effectively overcome. In this way, the photoelectric conversion efficiency of PERC solar cells can be effectively promoted, and the quality and reliability of the solar cells improved as well.

### BRIEF DESCRIPTION OF THE DRAWINGS

FIG. 1 is a schematic diagram showing a structure of an existing MBB front electrode (9 busbars).
FIG. 2 is a schematic diagram showing a structure of a front electrode of a solar cell according to a second embodiment.
FIG. 3 is a schematic diagram showing a partially enlarged view of the front electrode of the solar cell of the second embodiment.
FIG. 4 is a schematic diagram showing a structure of a front electrode of a solar cell according to a third embodiment.
FIG. 5 is a schematic diagram showing a partially enlarged view of the front electrode of the solar cell of the third embodiment.
FIG. 6 is a schematic diagram of a finger area of knotless screen according to an embodiment of the present disclosure.
FIG. 7 is a schematic diagram of a harpoon-shaped busbar area of knotless screen according to an embodiment of the present disclosure.
FIG. 8 is a schematic diagram showing a comparison between an existing straight harpoon-shaped busbar printing area and a S-type harpoon-shaped busbar printing area of an embodiment of the present disclosure.
FIG. 9 is a schematic diagram showing a busbar pattern by a step-by-step printing process.
FIG. 10 is a schematic diagram showing a finger pattern by a step-by-step printed process.
FIG. 11 is a schematic diagram showing a cross-section of a solar cell according to an embodiment of the present disclosure.
FIG.12 shows a laser SE pattern.
FIG. 13 is a schematic diagram showing a partial enlarged view of a laser doping area in FIG. 12.

In the drawings:
1: front electrode; 2: finger; 3: busbar; 3-1: solder joint; 3-2: fine busbar; 3-2-1: side fine busbar; 3-2-2: straight fine busbar; 3-3: edge harpoon-shaped fine busbar; 4: transverse wire of wire mesh; 5: longitudinal wire of wire mesh; 6: knot of longitudinal and transverse wires; 7: finger printing area; 8: transverse wire cut by laser in the finger printing area; 9-1:straight harpoon-shaped busbar printing area; 9-2: S-type harpoon-shaped busbar printing area; 10: silicon substrate; 11: front emitter; 11-1: lightly doped region; 11-2: heavily doped region; 12: front passivation and anti-reflection layer; 13: front oxide layer; 14: back passivation layer; 15: back finger electrode; 16: laser doping area of fingers; 16-1: laser spot.

### DETAILED DESCRIPTION OF THE EMBODIMENTS

In order to solve the problem that fingers of a front electrode is easily broken, or a current collection effect of busbars is effected after the busbars of the front electrode are connected to the solder scrips, thus affecting the quality and reliability of solar cell products, the present disclosure provides an optimized design of the busbar structure of the front electrode, that is, the structure of the busbar is designed as a composite structure which includes straight fine busbars 3-2-2 connected between adjacent solder joints and side fine busbars 3-2-1 located on both sides of the straight fine busbars 3-2-2 respectively. The busbar of the composite structure can effectively guarantee the current collection effect of the connection between the fine busbars and the solder scrips, and prevent the fingers from breaking at the soldering area of the busbars, that is, overcome the influence of the soldering of the fine busbar and the solder scrips in the existing front electrode on a solar cell and a solar cell module, and improve the quality and reliability of the solar cell and the solar cell module. In the present disclosure, the side fine busbars 3-2-1 are disposed divergently with respect to the solder joint 3-1, and a spacing W2 between the two side fine busbars 3-2-1 is greater than a width W1 of the solder joint 3-1, and each side fine busbar 3-2-1 can be a straight line or a curve line, preferably a straight line.

At present, the knotless screen mainly adopts a laser removal process of filaments, which has the advantages of high pattern making efficiency and high yield rate, and further does not need to change a pattern of the front electrode, etc., and gradually becomes mainstream. In this disclosure, the fingers are printed by using a knotless screen, which can eliminate knots in the warp and weft of the wire mesh on the fingers and effectively improve the ink permeability of the paste of the screen printing and fluctuation of a 3D shape of the grid lines. However, because of the inherent structural characteristics of the warp and weft of the wire mesh, it is difficult to achieve no knots on the fingers as well as no knots at a position where the busbars and the fingers intersect vertically and a position where the fingers and the harpoon-shaped busbars intersect vertically or diagonally while maintaining the tension and deformation requirements of the wire mesh. In the process of promoting the knotless technology, because of the using of silver paste with better plasticity and weaker fluidity, it is likely to form a missing printing area at the knot position in the busbar area, thus affecting the current collection effect, and further having a serious impact on the product quality and reliability in the case of long-term environmental aging. However, in this present disclosure, by optimizing the design of the busbar structure and the cooperation between the knotless screen technology and the optimized busbar structure, the above-mentioned problems in the knotless screen technology can be solved, and the quality and reliability of the solar cell and the solar cell module can be ensured.

In order to further understand technical solutions of this disclosure, the disclosure is described below with specific examples, by taking P-type monocrystalline silicon as an example.

### Example 1

Referring to FIG. 2 to FIG. 5, in the front electrode of the solar cell in this embodiment, the busbar 3 includes fine busbars 3-2 and solder joints 3-1 distributed on the fine busbars 3-2 at intervals. Each fine busbar 3-2 between two adjacent solder joints 3-1 includes a straight fine busbar 3-2-2 connecting the two adjacent solder joints 3-1, and side fine busbars 3-2-1 located on both sides of the straight fine busbar 3-2-2 respectively.

### Example 2

The structure of the front electrode of the solar cell in this embodiment is basically the same as that in the first example, specifically, in this embodiment, a width of the straight fine busbar 3-2-2 and a width of the side fine busbar 3-2-1 are both 0.06±0.04mm. The side fine busbars 3-2-1 are disposed divergently with respect to the solder joints 3-1, and a spacing W2 between the two side fine busbars 3-2-1 is greater than a width of the solder joint 3-1, and each side fine busbar 3-2-1 between adjacent solder joints 3-1 can be a straight line or a curve line.

### Example 3

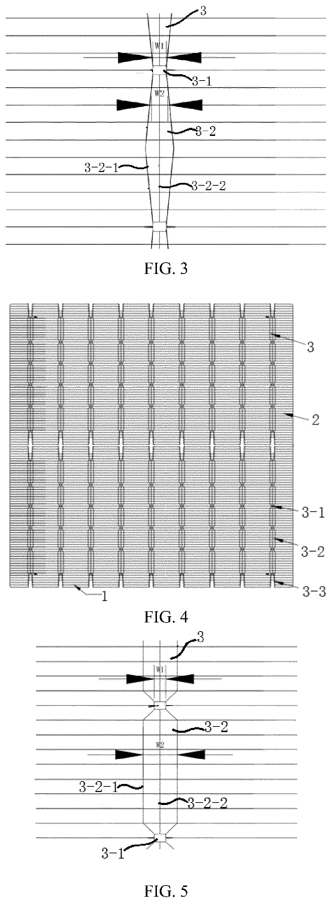

The structure of the front electrode of the solar cell in this embodiment is basically the same as that in the second example. Further, in this example, as shown in FIG. 2 and FIG. 3, each side fine busbar 3-2-1 between adjacent solder joints 3-1 is a curve line.

### Example 4

The structure of the front electrode of the solar cell in this embodiment is basically the same as that in the third example. The difference mainly lies in that, in this example, each side fine busbar 3-2-1 between adjacent solder joints 3-1 is a straight line, as shown in FIG. 4 and FIG. 5. In the case that the side fine busbars 3-2-1 are straight lines parallel to the straight fine busbar 3-2-2, it is better to configure the two ends of each side fine busbar 3-2-1 to be connected to the solder joint 3-1 respectively through a transition connection line. Preferably, the two ends of each straight fine busbar 3-2-2 are respectively connected to central regions of the two solder joints 3-1, and the two side fine busbars 3-2-1 are symmetrically distributed with respect to the straight fine busbar 3-2-2, that is, the straight fine busbar 3-2-2 between different solder joints 3-1 are in a common line.

### Example 5

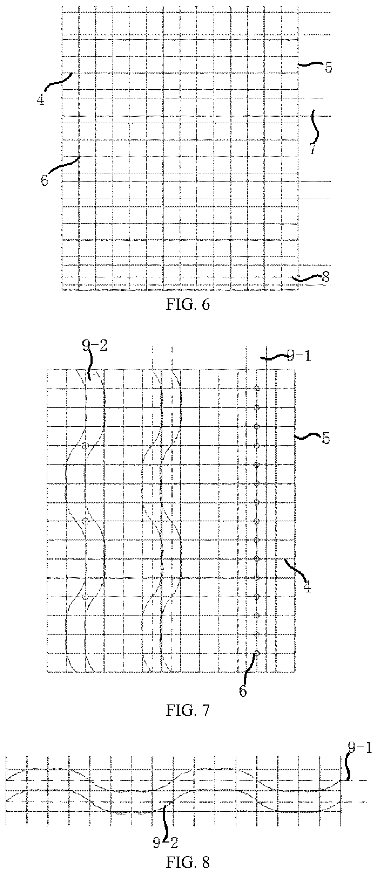

The structure of the front electrode of the solar cell in this embodiment is basically the same as that in the fourth example. The difference mainly lies in that, in this example, the fingers 2 are printed by using the knotless screen technology, and two ends of the fine busbars 3-2 are provided with edge harpoon-shaped fine busbars 3-3, and the edge harpoon-shaped fine busbar 3-3 is designed as an S-type curve line. As shown in FIG. 7 and FIG. 8, the comparison between a straight harpoon-shaped busbar printing area 9-1 and a S-type harpoon-shaped busbar printing area 9-2 shows that the use of S-type design can effectively reduce the knots formed by the longitudinal and transverse wires of the wire mesh in the harpoon-shaped busbar area by more than 80%, which is beneficial to further improve the quality and reliability of the solar cell products.

In a method for manufacturing the front electrode in this embodiment, the busbars 3 and the fingers 2 are prepared by using a step-by-step printing process. Specifically, the solder joints 3-1 and the fine busbars 3-2 are simultaneously printed during the printing of the busbar area, and the fingers 2 and the edge harpoon-shaped fine busbars 3-3 are simultaneously printed during the printing of the fingers area. The printing of the fingers area is performed by using the knotless screen, a spacing between adjacent fingers 2 ranges from 1.00mm to 1.32mm, and a width of the finger 2 ranges from 10µm to 26µm.

### Example 6

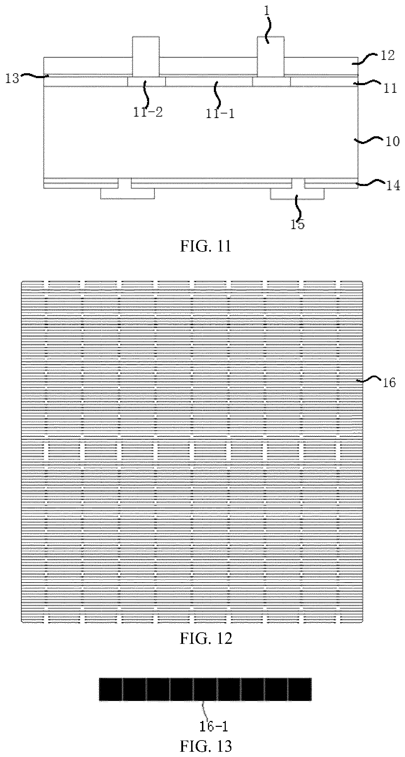

Referring to FIG. 11, a high-efficiency and high-reliability PERC solar cell of the present embodiment includes back finger electrodes 15, a back passivation layer 14, a silicon substrate 10, a front emitter 11, and a front passivation and anti-reflection layer 12. The front electrode 1 is located on a front surface of the front passivation and anti-reflection layer 12, and forms ohmic contact with the front emitter 11. The structure of the front electrode 1 is the same as that of the embodiment 5. Referring to FIG. 11, a method for manufacturing the solar cell of this embodiment includes the following steps.

At Step 1 of texturing, a texturing treatment is performed with alkali on a P-type monocrystalline silicon substrate 10 to form a textured surface structure on both a front surface and a back surface.

At Step 2 of diffusion, the texturized silicon substrate is reacted with phosphorus oxychloride at a high temperature, so that the front surface of the silicon substrate diffuses to form a PN emitter junction (i.e., the front emitter 11). A sheet resistance of a thin layer of the front surface after diffusion is between 160Ω/□.

At Step 3 of laser selective emitter (SE) process, the diffused phospho silicate glass serves as a phosphorus source, a laser doping process is performed on a metallization area located on the front surface of the diffused silicon substrate and corresponding to gate lines of the front electrode, to form a heavily doped region 11-2, thus the structure of the selective emitter (the heavily doped region 11-2 and the lightly doped region 11-1) is formed on the front surface of the silicon substrate. The sheet resistance of the heavily doped region is between 60Ω/□. As shown in FIG. 12, the laser SE doping is performed on the finger area of the pattern of the front electrode, as compared to the conventional laser pattern , the laser doping in the busbar area is eliminated, that is, the laser doping is performed only on a finger area 16, which increases the area of the lightly doped region, reduces surface recombination caused by heavy doping and laser process in this area, improves the short-wave effect, and is beneficial to further improve the conversion efficiency of the solar cell. As shown in FIG. 13, in order to ensure the overprinting accuracy of the front electrode and the laser-processed heavily doped area, and to ensure the stability of the yield rate in large-scale production, a laser SE spot is square or rectangular with a width of 90µm to 110µm, and a spacing between laser spots 16-1 varies between 0µm to 10µm.

At Step 4 of thermal oxidation, the silicon substrate is oxidized by oxygen after the laser SE process.

At Step 5 of PSG removal, a hydrofluoric (HF) is used to remove the PSG from the back surface and surrounding area of the silicon substrate after thermal oxidation.

At Step 6 of alkali polishing, the back surface and edges of the silicon substrate are polished after the PSG removing process, and the PSG on the front surface of the silicon substrate is removed.

At Step 7 of oxidation annealing, oxidation and annealing treatments are performed on the alkali polished silicon substrate to form the front oxide layer 13.

At Step 8 of deposition of a passivation film on the back surface, a passivation film is formed on the back surface of the annealed silicon substrate to form a back passivation layer 14.

At Step 9 of deposition of an anti-reflection film on the front surface, a front passivation and anti-reflection layer 12 is formed on the front surface of the silicon substrate.

At Step 10 of laser processing on the back surface, laser drilling is performed on the back surface of the silicon substrate having the passivation film.

At Step 11 of back electrode printing, the back electrodes are formed on the silicon substrate by screen printing after the laser drilling is performed on the front and back surfaces.

At Step 12 of printing back fingers, back finger electrodes 15 are formed on the silicon substrate having printed back electrodes, by screen printing.

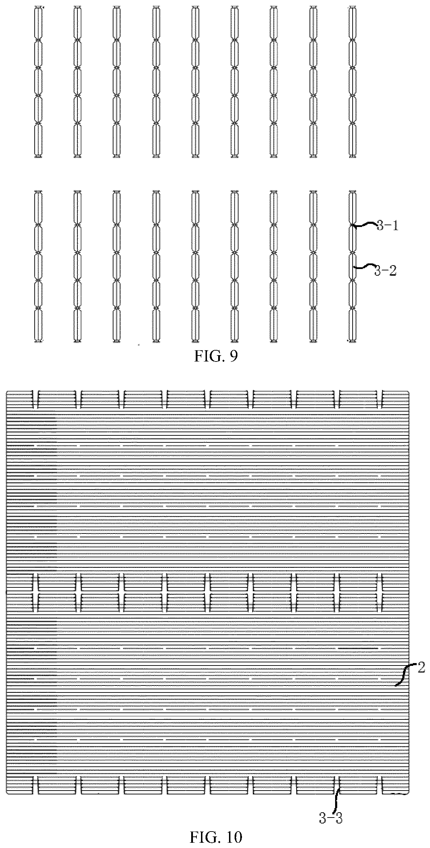

At Step 13 of printing the busbar area of the front electrode, front silver paste is used to perform screen printing on the silicon substrate, which includes printed back aluminum grid lines, to form the busbars of the front electrode. The front silver paste has a high solid content, a high solderability, and would not burn through silicon nitride (e.g., a solid content is 80-95%, tin area is more than 80%, an average value of tensile force is more than 1.0N, in this embodiment, polymerization M3M-FB07-6 is used). The busbar pattern is configured in a manner of using the solder joints of the busbars and the fine busbars (as shown in FIG. 9). The busbar adopts a multi-busbar structure which includes nine or more busbars, a width of each fine busbar is 0.05mm. The fine busbar can be designed with a bamboo gradient structure, and a gradient specification is 0.03mm to 0.1mm.

At Step 14 of printing the fingers area of the front electrode, knotless front silver paste is used to perform screen print on the silicon substrate, which includes printed front busbars of the front electrode, by using the knotless screen, to form the fingers of the front electrode. The front silver paste has a good high aspect ratio, and would burn through the silicon nitride (e.g., a high aspect ratio greater than 35%, in this embodiment, polymerization CSP-M3D-S6009V229 is used). Referring to FIG. 6, a process, e.g., a laser removal of filaments is performed to remove the wires parallel to the fingers in the printing area of fingers 7 (transverse wires 8 to be removed by laser in the printing area of fingers), thus eliminating the originally existed knots (i.e., the longitudinal and transverse wire knots 6) formed by the longitudinal wires 5 of the wire mesh and the transverse wires 4 of the wire mesh in the finger area. In this step, a pattern with fingers corresponding to the busbar pattern and the harpoon-shaped fine busbars (as shown in FIG. 10) is used. A spacing between adjacent fingers is 1.22mm, and the fingers are parallel and evenly spaced. A width of the finger is designed to be 22µm, and the harpoon-shaped fine busbars (as shown in FIG. 7) are designed to be S-type curve lines.

At Step 15 of sintering, the silicon substrate printed with the front electrode is co-sintered, and a peak sintering temperature can be selected between 720°C to 800°C as needed, in this embodiment, the temperature is 750°C.

At Step 16 of electrical injection and preparing finished product, the electrical injection process is performed on the sintered solar cells, after that, the solar cells are tested, sorted and packed into storage.

### Example 7

A solar cell of this embodiment has a same structure as the example 6. During manufacturing the solar cell, the spacing between adjacent fingers 2 can be reduced to 1.13mm, the width of the finger 2 can be reduced to 20µm, and the sintering temperature is 750°C.

### Example 8

A solar cell of this embodiment has a same structure as the example 6. During manufacturing the solar cell, the spacing between adjacent fingers 2 can be reduced to 1.32mm, the width of the finger 2 can be reduced to 24µm, and the sintering temperature is 760°C.

### Example 9

A solar cell of this embodiment has a same structure as the example 6. During manufacturing the solar cell, the spacing between adjacent fingers 2 can be reduced to 1.00mm, the width of the finger 2 can be reduced to 10µm, and the sintering temperature is 755°C.

According to the above embodiments, in the present disclosure, by designing multiple fine busbars of the composite structure and the S-type harpoon-shaped fine busbar structure, the knotless screen process for printing the fingers, and the step-by-step printing process of the busbar area and the finger area, the photoelectric conversion efficiency of the PERC solar cell can be improved by more than 0.1%, and the consumption of front silver paste can be reduced by 3-10mg. This can break the limitation that the paste of the fingers has a high requirement of tensile force on the busbar area, and the paste of the busbar area and the paste of the finger area can be selected separately as needed, thereby improving the metallization performance of the finger area. The width of the finger can be reduced to 10µm-26µm, and the spacing between adjacent fingers can be effectively reduced to 1.00mm -1.32mm.

## Claims

1. A front electrode of a solar cell, comprising:
busbars (3), comprising fine busbars (3-2) and solder joints (3-1) distributed on the fine busbars (3-2) at intervals;
wherein, each fine busbar (3-2) between two adjacent solder joints (3-1) comprises a straight fine busbar (3-2-2) connecting the two adjacent solder joints (3-1), and side fine busbars (3-2-1) located on both sides of the straight fine busbar (3-2-2) respectively.

2. The front electrode of the solar cell according to claim 1, wherein a width of the straight fine busbar (3-2-2) and a width of the side fine busbar (3-2-1) are both 0.06±0.04mm.

3. The front electrode of the solar cell according to claim 1, wherein the side fine busbars (3-2-1) are disposed divergently with respect to each solder joint (3-1), and a spacing W2 between two side fine busbars (3-2-1) is greater than a width W1 of the solder joint (3-1).

4. The front electrode of the solar cell according to claim 3, wherein each side fine busbar (3-2-1) between adjacent solder joints (3-1) is a straight line or a curve line.

5. The front electrode of the solar cell according to claim 3, wherein each side fine busbar (3-2-1) between adjacent solder joints (3-1) is a straight line parallel to the straight fine busbar (3-2-2), and two ends of each side fine busbar (3-2-1) are connected to the solder joints (3-1) respectively by a transition connection line.

6. The front electrode of the solar cell according to any one of claims 1 to 5, wherein two ends of each straight fine busbar (3-2-2) are connected to a central region of the two solder joints (3-1) respectively, and the side fine busbars (3-2-1) on both sides of each straight fine busbar (3-2-2) are symmetrically distributed with respect to the corresponding straight fine busbar (3-2-2).

7. The front electrode of the solar cell according to any one of claims 1 to 5, further comprising fingers (2), wherein the fingers (2) are printed by using a knotless screen; two ends of the fine busbars (3-2) are provided with edge harpoon-shaped fine busbars (3-3) respectively, and the edge harpoon-shaped fine busbars (3-3) are S-type curve lines.

8. The front electrode of the solar cell according to claim 7, wherein a spacing between adjacent fingers (2) ranges from 1.00mm to 1.32mm, and a width of each finger (2) ranges from 10µm to 26µm.

9. A method for manufacturing the front electrode of the solar cell according to any one of claims 1 to 8, comprising: forming the busbars (3) and the fingers (2) by using a step-by-step printing process.

10. The method according to claim 9, comprising:
printing the solder joints (3-1) and the fine busbars (3-2) synchronously during a process of printing the busbar area; and
printing the fingers (2) and the edge harpoon-shaped fine busbars (3-3) synchronously during a process of printing the finger area.

11. The method according to claim 10, comprising: forming the edge harpoon-shaped fine busbars (3-3) at two ends of the fine busbars (3-2).

12. The method according to claim 10, wherein the edge harpoon-shaped fine busbars (3-3) are S-type curve lines.

13. The method according to claim 9, wherein the fingers areas are printed by using a knotless screen, a spacing between adjacent fingers (2) ranges from 1.00mm to 1.32mm, and a width of the finger (2) ranges from 10µm to 26µm.

14. A solar cell, comprising the front electrode (1) according to any one of claims 1 to 8
